(19) Europäisches Patentamt
European Patent Office
Office européen des brevets

(11) **EP 2 161 744 A1**

(12) **EUROPEAN PATENT APPLICATION**
published in accordance with Art. 153(4) EPC

(43) Date of publication:
**10.03.2010 Bulletin 2010/10**

(21) Application number: **08764139.5**

(22) Date of filing: **16.06.2008**

(51) Int Cl.:
***H01L 23/02*** *(2006.01)* ***H01L 27/14*** *(2006.01)*
***H01L 31/02*** *(2006.01)*

(86) International application number:
**PCT/JP2008/001544**

(87) International publication number:
**WO 2008/155895 (24.12.2008 Gazette 2008/52)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **19.06.2007 JP 2007161459**

(71) Applicant: **Sumitomo Bakelite Co., Ltd.**
**Shinagawa-ku**
**Tokyo 140-0002 (JP)**

(72) Inventors:
- **TAKAHASHI, Toyosei**
  **Tokyo 140-0002 (JP)**
- **TAKAYAMA, Rie**
  **Tokyo 140-0002 (JP)**

(74) Representative: **Cramphorn, Conrad et al**
**Dr. Volker Vossius**
**Patent-und Rechtsanwaltskanzlei**
**Geibelstrasse 6**
**81679 München (DE)**

(54) **ELECTRONIC DEVICE MANUFACTURING METHOD**

(57) There is provided a process for manufacturing an electronic device, comprising an electronic component (a light receiving unit 11 and a base substrate 12 on which is placed the light receiving unit 11) and a substrate (a transparent substrate 13) which face each other and an adhesion layer 15, which bonds the electronic component to the substrate, containing a resin composition containing a photocurable resin, comprising forming the resin composition constituting the adhesion layer on the substrate or the electronic component; selectively exposing the resin composition with a light and developing the resin composition to form the frame-shaped adhesion layer in a predetermined region; placing the adhesion layer between the electronic component and the substrate; heating the electronic component, the substrate and the adhesion layer to a predetermined temperature, in the course of which the electronic component and the substrate are pressure-bonded through the adhesion layer; maintaining the pressure-bonding state of the electronic component, the substrate and the adhesion layer at the predetermined temperature; and cooling the electronic component, the substrate and the adhesion layer.

Fig.2

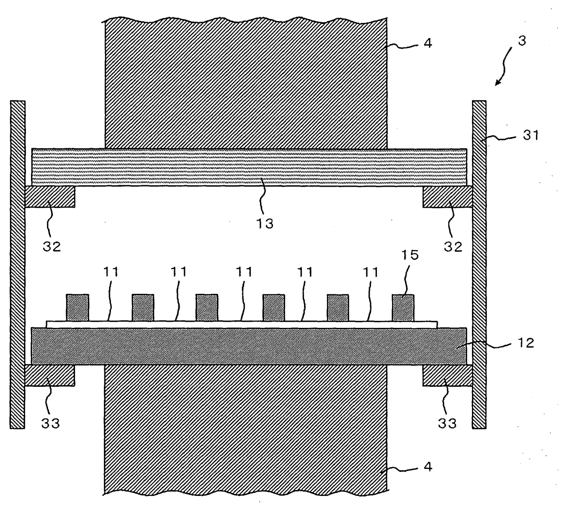


EP 2 161 744 A1

## Description

### TECHNICAL FIELD

The present invention relates to a process for manufacturing an electronic device having electronic components and a substrate.

### BACKGROUND ART

In some cases, an electronic device has been constituted by bonding electronic components to a substrate through, for example, an adhesion layer containing thermosetting resin such as a BCB (benzocyclobutene) resin as a main component.
For bonding electronic components to a substrate through such an adhesion layer, the adhesion layer must be maintained at a relatively higher temperature such that thermosetting can be adequately promoted. Thus, a pressure heater is heated to the predetermined temperature and after the pressure heater temperature becomes stable, the pressure heater is abutted against the substrate and the electronic components while the substrate, the adhesion layer and the electronic components are pressure-bonded by the pressure heater.
Meanwhile, there have been recently developed adhesion layers containing a resin composition containing a photocurable resin (for example, see Patent Reference 1).
The use of an adhesion layer containing such a resin composition containing a photocurable resin does not require heating at an high temperature in comparison with the use of a conventional adhesion layer containing a BCB (benzocyclobutene) resin as a main component, and, therefore, bonding of electronic components to a substrate is achieved by bonding the electronic components and the substrate through an adhesion layer under pressure at room temperature and then heating the electronic component, the substrate and the adhesion layer.
Patent Reference 1
Japanese laid-open patent publication No. 2006-70053

### MEANS FOR SOLVING PROBLEM

The conventional process for manufacturing an electronic device, however, has a problem of insufficient stability in producing an electronic device.
An objective of the present invention is to provide a process for manufacturing an electronic device, whereby production stability can be improved.
After investigation, we can suggest that production stability of an electronic device is deteriorated due to the following reasons.
In the conventional process for manufacturing an electronic device, as described above, bonding of electronic components to a substrate is achieved by bonding the electronic components and the substrate through an adhesion layer under pressure at room temperature and then heating the electronic component, the substrate and the adhesion layer. Bonding the electronic components and the substrate through an adhesion layer at room temperature results in inadequate adhesiveness of the adhesion layer to the electronic components and the substrate, leading to strain in the adhesion layer. Heating the electronic components, the substrate and the adhesion layer in such a state causes a residual stress to the adhesion layer, leading to peel-off of the adhesion layer from the electronic components and/or the substrate.
It probably leads to deterioration in adhesiveness of the electronic components to the substrate and thus insufficient stability in production of an electronic device.
The present invention has been devised on the basis of the findings and the suggestions as described above. In accordance with the present invention, there is provided a process for manufacturing an electronic device comprising an electronic component and a substrate which face each other and a frame-shaped adhesion layer, which bonds said electronic component to said substrate, containing a resin composition containing a photocurable resin, comprising forming the resin composition constituting said adhesion layer on said substrate or said electronic component; selectively exposing said resin composition with a light and developing the resin composition to form said frame-shaped adhesion layer in a predetermined region; placing said electronic component and said substrate such that these face each other, through said adhesion layer; heating said electronic component, said substrate and said adhesion layer to a predetermined temperature, in the course of which said electronic component and said substrate are pressure-bonded through said adhesion layer; maintaining the pressure-bonding state of said electronic component, said substrate and said adhesion layer at said predetermined temperature; and cooling said electronic component, said substrate and said

adhesion layer.

According to the present invention, the electronic component, the adhesion layer and the substrate are pressure-bonded while the electronic component, the adhesion layer and the substrate are heated to a predetermined temperature. Since the electronic component, the adhesion layer and the substrate can be pressure-bonded when the adhesion layer becomes soft due to reduction in a viscosity by the heating, adhesiveness between the adhesion layer and the electronic component and between the adhesion layer and the substrate can be improved.

Thus, adhesiveness between the substrate and the electronic component can be improved, resulting in improved stability in producing an electronic device.

Here, in said heating said electronic component, said substrate and said adhesion layer to a predetermined temperature, the pressure-bonding of said electronic component, said adhesion layer and said substrate is preferably initiated at T1 at which the viscosity of said resin composition constituting said adhesion layer reaches 80 % of said resin composition at 25 ˚C, or a higher temperature.

By initiating the pressure-bonding of the electronic component, the adhesion layer and the substrate adhesion layer at T1 at which the viscosity of said resin composition constituting said adhesion layer reaches 80 % of said resin composition at 25 ˚C, or a higher temperature, the electronic component, the adhesion layer and the substrate can be pressure-bonded when the viscosity of the adhesion layer is adequately reduced by the heating. It can improve wettability of the adhesion layer to the electronic component and the substrate.

At T1 at which the viscosity of the resin composition constituting the adhesion layer reaches 80 % of the resin composition at 25 ˚C, or a higher temperature, the viscosity of the adhesion layer is reduced, so that bubbles in the adhesion layer are removed to some extent. Thus, it can prevent air from entering an interface between the adhesion layer and the electronic component, and an interface between the adhesion layer and the substrate.

It can reliably improve adhesiveness between the adhesion layer and the electronic component and between the adhesion layer and the substrate.

Furthermore, it is preferable that said resin composition contains a thermosetting resin and that in said heating said electronic component, said substrate and said adhesion layer to a predetermined temperature, the pressure-bonding of said electronic component, said adhesion layer and said substrate is initiated at T2 giving the lowest melt viscosity, which is determined by heating said resin composition constituting said adhesion layer from 25 ˚C to 250 ˚C at a ramp up rate of 10 ˚C/min, or a lower temperature.

Thus, by initiating the pressure-bonding of said electronic component, said substrate and said adhesion layer at T2 giving the lowest melt viscosity or lower, the electronic component, the adhesion layer and the substrate can be pressure-bonded before thermal curing of the resin composition in the adhesion layer is initiated. It can reliably improve adhesiveness between the adhesion layer and the electronic component and between the adhesion layer and the substrate.

In said cooling said electronic component, said substrate and said adhesion layer, it is preferable that a pressure applied to said electronic component, said substrate and said adhesion layer is released during said cooling said electronic component, said substrate and said adhesion layer.

Furthermore, it is preferable that said resin composition contains a thermosetting resin and that in said cooling said electronic component, said substrate and said adhesion layer, a pressure applied to said electronic component, said substrate and said adhesion layer is released at T3 which is lower than said predetermined temperature and at which said resin composition has a storage elastic modulus G' of 0.03 MPa, or a lower temperature.

It can prevent bubbles in the adhesion layer.

Said resin composition preferably contains (i) an epoxy resin, (ii) a photocurable resin and (ii) a photopolymerization initiator.

Furthermore, in said pressure-bonding said electronic component and said substrate through said adhesion layer of the present invention, it is preferable that said electronic component and said substrate are pressure-bonded (pressure-bonding is initiated) through said adhesion layer when a temperature of said electronic component, said substrate and said adhesion layer is 40 ˚C or higher and 100 ˚C or lower.

Furthermore, in the present invention, it is preferable that said substrate is a transparent substrate, and said electronic component has a light receiving unit and a base substrate on which the light receiving unit is formed, and the electronic device is a light receiving device.

The present invention provides a process for manufacturing an electronic device whereby an electronic device can be produced with improved production stability.

## BRIEF DESCRIPTION OF THE DRAWINGS

The obj ective described above and other obj ectives, the features and the advantages of the present invention will be clearly understood with reference to suitable embodiments as described below and the following accompanying drawings.

FIG. 1 shows a production process for a light receiving device of this embodiment.
FIG. 2 shows a device for pressure-bonding of a transparent substrate and a base substrate in a light receiving device.
FIG. 3 shows a production process for a light receiving device of this embodiment.
FIG. 4 shows a temperature profile and a pressure profile in a production process for a light receiving device of this embodiment.
FIG. 5 shows a light receiving device of this embodiment.

BEST MODE FOR CARRYING OUT THE INVENTION

Embodiments of the present invention will be described with reference to the drawings.
FIGs. 1 to 3 show a production process for a light receiving device 1 (see FIG. 5) which is an electronic device of this embodiment.
A manufacturing process of this embodiment is a process for manufacturing a light receiving device 1 comprising an electronic component (a light receiving unit 11 and a base substrate 12 on which the light receiving unit 11 is placed) and a substrate (a transparent substrate 13) which face each other and a frame-shaped adhesion layer 15, which bonds the electronic component to the substrate, containing a resin composition containing a photocurable resin.
This process for manufacturing the light receiving device 1 includes forming the resin composition constituting the adhesion layer on the substrate or the electronic component; selectively exposing the resin composition with a light and developing the resin composition to form the frame-shaped adhesion layer in a predetermined region; placing the adhesion layer between the electronic component and the substrate; heating the electronic component, the substrate and the adhesion layer to a predetermined temperature, in the course of which the electronic component and the substrate are pressure-bonded through the adhesion layer; maintaining the pressure-bonding state of the electronic component, the substrate and the adhesion layer at the predetermined temperature; and cooling the electronic component, the substrate and the adhesion layer.
There will be detailed a process for manufacturing a light receiving device according to this embodiment.
First, as shown in FIG. 1(A), a base substrate 12 having a plurality of light receiving units 11 is prepared. Specifically, a microlens array is formed on the base substrate 12.
The lower surface of this microlens array, that is, a base substrate, has a photoelectric conversion unit (not shown), where a light received by the light receiving unit 11 is converted to an electric signal.
Next, as shown in FIG. 1(B), a photocurable adhesion film 14 is attached such that it covers the surface of this base substrate 12 (the surface having the light receiving unit 11).
The adhesion film 14 constitutes an adhesion layer 15. This adhesion film 14 is made of a resin composition containing a photocurable resin.
Examples of the photocurable resin include ultraviolet curable resins containing an acrylic compound as a main component; ultraviolet curable resins containing an urethane acrylate oligomer or a polyester urethane acrylate oligomer as a main component; and ultraviolet curable resin containing at least one selected from the group consisting of an epoxy resin, a vinyl phenol resin, a bismaleimide resin and a diallyl phthalate resin as a main component.
Among these, an ultraviolet curable resin containing an acrylic compound as a main component is preferable. Since an acrylic compound is rapidly cured by light exposure, a resin can be patterned with a relatively small exposure amount.
The acrylic compound can be any compound having a (meth) acryloyl group including, but not limited to, monofunctional (meth)acrylates having one (meth)acryloyl group, bifunctional (meth)acrylates having two (meth)acryloyl groups and polyfunctional (meth)acrylates having three or more (meth)acryloyl groups; more specifically, bifunctional (meth)acrylates such as ethyleneglycol di(meth)acrylate, 1,6-hexanediol di(meth)acrylate, glycerol di(meth)acrylate and 1,10-decanediol di(meth)acrylate and polyfunctional (meth)acrylates such as trimethylolpropane tri(meth)acrylate, pentaerythritol tri(meth)acrylate and dipentaerythritol hexa(meth)acrylate. The acrylic compound also includes polyalkyleneglycol di(meth)acrylates such as polyethyleneglycol di(meth)acrylate and polypropyleneglycol di(meth)acrylate. The acrylic compound can further include urethane (meth)acrylates and epoxy (meth)acrylates.
Among the acrylic compounds, preferred are bifunctional (meth)acrylates such as triethyleneglycol di(meth) acrylate, 1,6-hexanediol di(meth)acrylate, glycerol di(meth)acrylate and 1,10-decanediol di(meth)acrylate, particularly triethyleneglycol di(meth)acrylate in the light of excellent balance between photocuring reactivity and toughenss of a photosensitive adhesive resin composition.
The content of a photocurable resin (an ultraviolet curable resin) is, but not limited to, preferably 5 % by weight or more and 60 % by weight or less, particularly preferably 8 % by weight or more and 30 % by weight or less to the total of the resin composition constituting the adhesion film 14. With the content being less than 5 % by weight, the adhesion film 14 may not be patterned by ultraviolet exposure, while with the content being more than 60 % by weight, the resin becomes so soft that sheet properties before ultraviolet exposure may be deteriorated.
Furthermore, the adhesion film 14 preferably contains a photopolymerization initiator.
It allows the adhesion film 14 to be efficiently patterned by photopolymerization.

Examples of the photopolymerization initiator include benzophenone, acetophenone, benzoin, benzoin isobutyl ether, methyl benzoin benzoate, benzoin benzoic acid, benzoin methyl ether, benzyl phenyl sulfide, benzil, dibenzyl and diacetyl. The content of the photopolymerization initiator is, but not limited to, preferably 0.5 % by weight or more and 5 % by weight or less, particularly preferably 0. 8 % by weight or more and 2.5 % by weight or less to the total of the resin composition. With the content being less than 0.5 % by weight, photopolymerization may be less effectively initiated, while with the content being more than 5 % by weight, the system becomes so reactive that storage stability and/or resolution power may be reduced.

Furthermore, the adhesion film 14 contains a thermosetting resin. Examples of the thermosetting resin include novolac type phenol resins such as phenol novolac resins, cresol novolac resins and bisphenol-A novolac resin; phenol resins such as resol phenol resins; bisphenol type epoxy resins such as bisphenol-A epoxy resins and bisphenol-F epoxy resins; novolac type epoxy resins such as phenol novolac epoxy resins, cresol novolac epoxy resins and bisphenol-A novolac epoxys; epoxy resins such as biphenyl type epoxy resins, stilbene type epoxy resins, triphenol methane type epoxy resins, alkyl-modified triphenol methane type epoxy resins, triazine-containing epoxy resins and dicyclopentadiene-modified phenol type epoxy resins; triazine-ring containing resins such as urea resins and melamine resins; unsaturated polyester resins; bismaleimide resins; polyurethane resins; diallyl phthalate resins; silicone resins; benzoxazine-ring containing resins; and cyanate ester resins, which can be used alone or in combination. Among these, epoxy resins are particularly preferable. It can further improve heat resistance and adhesiveness.

Furthermore, the epoxy resin described above is preferably a combination of an epoxy resin which is solid at room temperature (particularly, a bisphenol type epoxy resin) and an epoxy resin which is liquid at room temperature (particularly, a silicone-modified epoxy resin which is liquid at room temperature). It can provide an adhesion film 14 which is excellent in both flexibility and resolution while maintaining heat resistance.

The content of the thermosetting resin is, but not limited to, preferably 10 % by weight or more and 40 % by weight or less, particularly preferably 15 % by weight or more and 35 % by weight or less, to the total of the resin composition constituting the adhesion film 14. With the content being less than 10 % by weight, heat resistance may be insufficiently improved, while with the content being more than 40 % by weight, toughenss of the adhesion film 14 may be insufficiently improved.

Furthermore, the adhesion film 14 preferably contains a curing resin which is curable by both light and heat. It can improve compatibility of the photocurable resin with the thermosetting resin, resulting in improved strength of the adhesion film 14 after curing (photo- and thermo-curing).

Examples of a curing resin which can be cured by both light and heat include thermosetting resins having a photoreactive group such as acryloyl, methacryloyl and vinyl and photocurable resins having a thermally reactive group such as epoxy, phenolic hydroxy, alcoholic hydroxy, carboxyl, acidanhydride, amino and cyanate. Specific examples include (meth)acryl-modified phenol resins, acryl copolymerized resins having a carboxyl and a (meth) acryl groups in a side chain, (meth) acrylic acid polymers containing a (meth) acryloyl group and epoxy acrylate resins containing a carboxyl group. Among these, (meth) acryl-modified phenol resins are preferable. It allows for the use of an aqueous alkaline solution having little effect on the environment instead of an organic solvent as a developer and maintaining heat resistance.

For the thermosetting resin having a photoreactive group described above, a modification rate (a substitution rate) of the photoreactive group is, but not limited to, preferably 20 % or more and 80 % or less, particularly preferably 30 % or more and 70 % or less to the total of reactive groups in the curing resin which is curable by both light and heat (the total of photoreactive and thermally reactive groups). The modification rate within the above range can provides particularly excellent resolution.

For the photocurable resin having a thermally reactive group described above, a modification rate (a substitution rate) of the thermally reactive group is, but not limited to, preferably 20 % or more and 80 % or less, particularly preferably 30 % or more and 70 % or less, to the total of reactive groups in the curing resin which is curable by both light and heat (the total of photoreactive and thermally reactive groups). The modification rate within the above range can provides particularly excellent resolution.

The content of the curing resin which is curable by both light and heat is, but not limited to, preferably 15 % by weight or more and 50 % by weight or less, particularly preferably 20 % by weight or more and 40 % by weight or less to the total of the resin composition constituting the adhesion film 14. With the content being less than 15 % by weight, compatibility may be insufficiently improved while with the content being more than 50 % by weight, developing properties and resolution may be deteriorated.

The adhesion film 14 preferably contains a filler. The filler is an important component through which a permeability of the adhesion film 14 can be controlled.

Examples of the filler include fibrous fillers such as alumina fiber and glass fiber; needle fillers such as potassium titanate, wollastonite, aluminum borate, needle magnesium hydroxide and whisker; plate-like fillers such as talc, mica, sericite, glass flake, flake graphite and plate-like calcium carbonate; spherical (granular) fillers such as calcium carbonate, silica, fused silica, calcined clay and uncalcined clay; and porous fillers such as zeolite and silica gel. These can be used alone

or in combination of two or more. Among these, silica and porous fillers are preferable.

The resin composition constituting the adhesion film 14 can contain, in addition to a curing resin and a filler as described above, a plastic resin, a leveling agent, a defoaming agent and a coupling agent as long as the aim of the present invention can be achieved.

The resin composition described above can contain, for example,

(i) an epoxy resin
(ii) a photocurable resin and
(iii) a photopolymerization initiator.

Furthermore, the resin composition can contain a curing resin which can be cured by both light and heat.

Next, the adhesion film 14 is selectively exposed with light (for example, ultraviolet) using a photomask. Thus, the exposed region in the adhesion film 14 is photo-cured. By developing the adhesion film 14 after exposure with a developer (for example, an aqueous alkali solution, an organic solvent and soon), the exposed region is not dissolved in the developer and remains. In the region except each light receiving unit 11 on the base substrate 12, the adhesion film 14 is left such that it surrounds the light receiving unit 11 (see, FIG. 1(C)). Specifically, the adhesion film 14 is left as a frame (here, a plurality of frame-shaped parts as a grid). Thus, a frame-shaped (grid) adhesion layer 15 is formed.

Then, adhesion layer 15 bonds the base substrate 12 having the light receiving unit 11 to the transparent substrate 13.

The base substrate 12 with the adhesion layer 15 and the transparent substrate 13 is placed in a chamber (not shown). Within the chamber, there is placed the periphery of the base substrate 12 and a holding material 3 holding the periphery of the transparent substrate 13 as shown in FIG. 2. This holding material 3 has a ring frame 31 and clicks 32,33 protruding from the frame 31 toward the center of the ring. The click 32 is above the click 33.

The periphery of the transparent substrate 13 is placed on the click 32 while the periphery of the base substrate 12 is placed on the click 33. The holding material 3 holds the base substrate 12 and the transparent substrate 13 such that these face each other.

Each of the rear face of the base substrate 12 held by the holding material 3 and the rear face of the transparent substrate 13, a pressure-binding material 4 for pressure-bonding the base substrate 12 and the transparent substrate 13 is placed. Within the pressure-binding material 4, a heater (not shown) is placed and the base substrate 12, the adhesion layer 15 and the transparent substrate 13 are heated while the pressure-binding material 4 abuts the base substrate 12 and the transparent substrate 13.

FIG. 4 shows a temperature and a pressure profiles in bonding the base substrate 12 having the light receiving unit 11 with the transparent substrate 13 through the adhesion layer 15. The temperature profile shows temperatures of the base substrate 12, the adhesion layer 15 and the transparent substrate 13, while the pressure profile shows pressures on the base substrate 12, the adhesion layer 15 and the transparent substrate 13. In FIG. 4, A and B are a pressure and a temperature profiles, respectively.

First, while the holding material 3 holds the base substrate 12 and the transparent substrate 13, the pressure-binding material 4 is sandwiched between the rear face of the base substrate 12 and the rear face of the transparent substrate 13, and then the base substrate 12, the transparent substrate 13 and the adhesion layer 15 are heated to a predetermined temperature (for example, 120 ˚C).

In the step of heating to a predetermined temperature (for example, 120 ˚C), a ramp up rate is preferably 10 ˚C/min or more. Thus, a time for producing a light receiving device can be reduced. Furthermore, it can reduce a heat history to the adhesion layer 15 before initiation of the pressure-bonding, so that advance of thermal curing before pressure-bonding and therefore defective adhesion can be prevented.

In the production of light receiving devices, the pressure-binding material 4, which is not heated, is heated from room temperature when a light receiving device is produced for the first time and in second or further run of producing a light receiving device, the pressure-binding material 4 can be heated from about 60 ˚C without cooling it to room temperature, too.

In the heating of the base substrate 12, the transparent substrate 13 and adhesion layer 15 to the predetermined temperature, the base substrate 12, the transparent substrate 13 and the adhesion layer 15 are pressure-bonded.

Specifically, for example, pressure-bonding is initiated when the base substrate 12, the transparent substrate 13 and the adhesion layer 15 reach a temperature T1 at which a viscosity of the resin composition constituting the adhesion layer 15 becomes 80 % of a viscosity of the resin composition at room temperature (25 ˚C), or a higher temperature.

More preferably, pressure-bonding is initiated at T4 at which a viscosity of the resin composition becomes 70 % of a viscosity of the resin composition at room temperature (25˚C), or a higher temperature.

Here, T1 can be determined as follows.

On a PET film is formed an adhesion film 14 to a thickness of 50 μm. Then, the film is cut to prepare three samples with the size of 30 mm × 30 mm. Each of the samples is exposed with a broadband light. A light quantity is 700 mJ/cm$^2$ at

a wavelength of 365 nm. The adhesion film 14 is removed from the PET film, and three films are set to a dynamic viscoelastic measurement apparatus Rheo Stress RS150 (HAAKE). A viscosity Eta is determined by measurement from 25 ˚C to 250 ˚C with an inter-plate gap of 50 μm, a frequency of 1 Hz and a ramp up rate of 10 ˚C/min.
From the data indicating relationship between a viscosity and a temperature, a temperature corresponding to a viscosity of 0.8 folds of that at 25 ˚C is read as T1. T4 can be determined in the same manner.
It can be regarded that a temperature of the pressure-binding material4 is equal to that of the transparent substrate 13, the base substrate 12 and the adhesion layer 15.

Pressure-bonding is initiated when a temperature of the base substrate 12, the transparent substrate 13 and the adhesion layer 15 is T2 at which a melt viscosity is lowest when the resin composition constituting the adhesion layer 15 is heated from room temperature (25 ˚C) to 250 ˚C at a ramp up rate of 10 ˚C/min, or a lower temperature.

Here, T2 can be determined as follows.
Data on temperature dependency of a viscosity are obtained by the viscometric measurement as described for determination of T1. A temperature at which a viscosity is lowest in the viscosity data is determined to be a lowest melt viscosity temperature T2.
More preferably, pressure-bonding is initiated at T2-10 ˚C or lower.
Specifically, pressure-bonding is preferably initiated at a temperature of 40 ˚C or higher and 100 ˚C or lower.

When pressure-bonding is initiated, the pressure-binding material 4 in the side of base substrate 12 moves up to the side of the transparent substrate 13. The click 32 in the holding material 3 moves to the side of frame 31 and the transparent substrate 13 is pushed by the pressure-binding material 4 to move down to the side of the base substrate 12. A pair of the pressure-binding materials 4 sandwich the base substrate 12, the transparent substrate 13 and the adhesion layer 15 while the base substrate 12 and the transparent substrate 13 are pressure-bonded through the adhesion layer 15 by a predetermined pressure.
Then, while the pressure-binding materials 4 press-bond the base substrate 12, the transparent substrate 13 and the adhesion layer 15, the base substrate 12 and the transparent substrate 13 is heated to a predetermined temperature.
Vacuuming is preferably initiated before initiating the heating of the base substrate 12, the transparent substrate 13 and the adhesion layer 15.
Next, the pressure-bonding state of the base substrate 12, the transparent substrate 13 and the adhesion layer 15 is maintained for a predetermined period.

Subsequently, cooling of the base substrate 12, the transparent substrate 13 and the adhesion layer 15 is started.
During the step of cooling the base substrate 12, the transparent substrate 13 and the adhesion layer 15, a sandwiching pressure to the base substrate 12, the transparent substrate 13 and the adhesion layer 15 by the pressure-binding materials 4 is released.
In this cooling process, the product is cooled to a predetermined temperature (for example, room temperature), and a cooling rate is preferably 10 ˚C/min or more. Thus, a time required for producing a light receiving device can be reduced.
In the cooling, the product can be cooled not to room temperature but to about 60 ˚C, and the base substrate 12, the transparent substrate 13 and the adhesion layer 15 can be removed from the pressure-binding materials 4.
It is preferable to release a pressure applied to the base substrate 12, the transparent substrate 13 and the adhesion layer 15 at T3 which is lower the predetermined temperature at which pressure-bonding of the base substrate 12, the transparent substrate 13 and the adhesion layer 15 is maintained and at which a storage elastic modulus G' of the resin composition constituting the adhesion layer 15 is 0.03 MPa, or a lower temperature.

T3 can be determined as follows.
On a PET film is formed an adhesion film 14 to a thickness of 50 μm. Then, the film is cut to prepare three samples with the size of 30 mm × 30 mm. Each of the samples is exposed with a broadband light. A light quantity is 700 mJ/cm$^2$ at a wavelength of 365 nm. The adhesion film 14 is removed from the PET film, and three films are set to a dynamic viscoelastic measurement apparatus Rheo Stress RS150 (HAAKE). A storage elastic modulus G' is determined by measurement from 25 ˚C to 250 ˚C with an inter-plate gap of 50 μm, a frequency of 1 Hz and a ramp up rate of 10 ˚C/min ,
Then, data on temperature dependency of a storage elasticmodulus G' are obtained. A temperature which is lower than the predetermined temperature (heating-maintaining temperature) and at which a storage elastic modulus G' measured is 0.03 MPa is determined as T3.

Preferably, on or 5 min after initiating cooling of the base substrate 12, the transparent substrate 13 and the adhesion layer 15, vacuuming of the chamber is released.
At the end of cooling of the base substrate 12, the transparent substrate 13 and the adhesion layer 15, these are post-cured for completing curing of the adhesion layer 15. At the end of the cooling step, a thermosetting reaction rate of the adhesion layer 15 is, for example, about 10 %.
Post-curing is specifically, for example, heating of the base substrate 12, the transparent substrate 13 and the adhesion layer 15 at a temperature of 100 to 200 ˚C for 30 min to 180 min. Thus, a thermosetting reaction rate of the adhesion layer 15 becomes 90 % or more.

Then, the base substrate 12 and the transparent substrate 13 bonded are diced for each light receiving unit

(see FIG. 3).
Specifically, first, while water is fed to the base substrate 12, the base substrate 12 is cut by a dicing saw to form a trench 12B.
Then, a metal layer (not shown) is formed by, for example, sputtering such that it covers the side of the trench 12B and the bottom of the base substrate 12.
Next, the product is cut from the side of the transparent substrate 13 by a dicing saw and the base substrate 12 and the transparent substrate 13 are diced for each light receiving unit. Again, dicing is conducted while water is fed to the base substrate 12, the transparent substrate 13 and the adhesion layer 15.
Since the adhesion layer 15 after exposure remains in the region except the light receiving unit 11, the adhesion layer 15 is also diced when the base substrate 12 and the transparent substrate 13 are diced for each light receiving unit.
The above process can provide the light receiving device 1 as shown in FIG. 5.
The light receiving device 1 has the base substrate 12 having a light receiving unit 11 and the transparent substrate 13 facing the base substrate 12, where the frame-shaped adhesion layer 15 ensuring a gap between the base substrate 12 and the transparent substrate 13 and surrounding the light receiving unit 11 is placed between the transparent substrate 13 and the base substrate 12.
There will be described effects of this embodiment.
In the course of the heating step during which the transparent substrate 13, the base substrate 12 having the light receiving unit 11 and the adhesion layer 15 are heated to a predetermined temperature, the transparent substrate 13, the base substrate 12 having the light receiving unit 11 and the adhesion layer 15 are pressure-bonded. The transparent substrate 13, the base substrate 12 having the light receiving unit 11 and the adhesion layer 15 are pressure-bonded when the adhesion layer 15 becomes soft with a reduced viscosity by heating, so that adhesiveness between the adhesion layer 15 and the base substrate 12 and between the adhesion layer 15 and the transparent substrate 13 can be improved.
Thus, adhesiveness between the transparent substrate 13 and the base substrate 12 canbe improved and therefore, stability in producing a light receiving device 1 can be improved.
In this embodiment, pressure-bonding of the transparent substrate 13, the adhesion layer 15 and the base substrate 12 is initiated at T1 at which a viscosity of the adhesion layer 15 becomes 80 % of a viscosity of the adhesion film 14 at room temperature (25 ˚C), or a higher temperature.
By initiating pressure-bonding at such a temperature T1 or higher, the transparent substrate 13, the adhesion layer 15 and the base substrate 12 can be pressure-bonded while a viscosity of the adhesion layer 15 is reduced by heating. It can improve wettability of the adhesion layer 15 to the base substrate 12 and to the transparent substrate 13.
Furthermore, at a temperature T1 or higher, a viscosity of the adhesion layer 15 is reduced, so that bubbles in the adhesion layer 15 are removed to some extent. It can prevent air from entering an interface between the adhesion layer 15 and the base substrate 12, and an interface between the adhesion layer 15 and the transparent substrate 13.
As described above, adhesiveness between the adhesion layer 15 and the base substrate 12 and adhesiveness between the adhesion layer 15 and the transparent substrate 13 can be reliably improved and the adhesion layer 15 and the base substrate 12 as well as the adhesion layer 15 and the transparent substrate 13 can be reliably bonded.
Particularly, by initiating pressure-bonding at T4 at which a viscosity of the resin composition becomes 70 % of a viscosity of the resin composition at room temperature (25 ˚C), or a higher temperature, adhesiveness between the adhesion layer 15 and the base substrate 12 and adhesiveness between the adhesion layer 15 and the transparent substrate 13 can be reliably improved.
Furthermore, in this embodiment, by initiating pressure-bonding of the transparent substrate 13, the adhesion layer 15 and the base substrate 12 at T2 at which the adhesion layer 15 has the lowest melt viscosity or lower, the transparent substrate 13, the adhesion layer 15 and the base substrate 12 can be pressure-bonded before initiation of curing of the resin composition in the adhesion layer 15. It can reliably improve adhesiveness between the adhesion layer 15 and the base substrate 12 and adhesiveness between the adhesion layer 15 and the transparent substrate 13.
Particularly, initiation of pressure-bonding at T2-10 ˚C or lower can reliably improve adhesiveness between the adhesion layer 15 and the base substrate 12 and adhesiveness between the adhesion layer 15 and the transparent substrate 13.
Furthermore, in this embodiment, a pressure applied to the transparent substrate 13, the adhesion layer 15 and the base substrate 12 is released when a temperature of the transparent substrate 13, the adhesion layer 15 and the base substrate 12 is T3 at which a storage elastic modulus G' of the resin composition constituting the adhesion layer 15 is 0.03 MPa, or a lower temperature. It can prevent bubbles from entering the adhesion layer 15.
The resin composition for the adhesion layer 15 contains (i) an epoxy resin, (ii) a photocurable resin and (iii) a photopolymerization initiator, but when such a resin composition is used, a conventional production process permits bubbles to enter, leading to deterioration in an adhesive force. In contrast, employing the manufacturing process of this embodiment can prevent entering of bubbles and deterioration in an adhesive force.
The present invention is not limited to the embodiment described above, and variations and modifications are encompassed within the present invention as long as the objectives of the present invention can be achieved.

For example, in the above embodiment, the adhesion film 14 which is a resin composition formed as a film is laminated with the base substrate 12 and the base substrate 12 is bonded to the transparent substrate 13, but without being limited to the embodiment, the adhesion film 14 may be laminated with the transparent substrate 13.

In the above embodiment, the adhesion film 14 is laminated with the base substrate 12, then transparent substrate 13 is bonded through the adhesion film 14, and then the product is diced, but without being limited to the embodiment, the adhesion film 14 can be laminated with the base substrate 12, then the base substrate 12 can be diced for each light receiving unit and then the transparent substrate 13 can be bonded.

In the above embodiment, the adhesion film 14 which is a resin composition formed as a film is laminated with the base substrate 12, but without being limited to the embodiment, a varnish resin composition can be applied to the base substrate 12. After the varnish resin composition is applied to the base substrate 12, it is dried, exposed and developed. Subsequently, as described for the embodiment, the transparent substrate 13 can be bonded to prepare a light receiving device 1.

For example, a resin composition can be prepared as described below.

A resin composition contains (A) a cyclic olefinic resin having a photoreactive functional group, (B) an acid generator and (C) a compound curable by the action of the acid generator.

Examples of a cyclic olefinic resin constituting (A) a cyclic olefinic compound having a photoreactive functional group include, but not limited to, polymers of a monocyclic olefinic monomer such as cyclohexenes and cyclooctenes; and polymers of a polycyclic olefinic monomer such as norbornenes, norbornadienes, dicyclopentadienes, dihydrodicyclopentadienes, tetracyclododecenes, tricyclopentadienes, dihydrotricyclopentadienes, tetracyclopentadienes and dihydrotetracyclopentadienes. Among these, polymers of a polycyclic olefinic monomer exhibiting good moisture resistance and chemical resistance are preferable, and norbornene monomers are particularly preferable in the light of heat resistance and mechanical strength of a photosensitive resin composition after curing.

Examples of the above norbornene monomer include, but not limited to, 2-norbornene; alkyl-containing norbornenes such as 5-methyl-2-norbornene, 5-ethyl-2-norbornene, 5-propyl-2-norbornene, 5-butyl-2-norbornene, 5-pentyl-2-norbornene, 5-hexyl-2-norbornene, 5-heptyl-2-norbornene, 5-octyl-2-norbornene,5-nonyl-2-norbornene and 5-decyl-2-norbornene; alkenyl-containing norbornenes such as 5-allyl-2-norbornene, 5-methylidene-2-norbornene, 5-ethylidene-2-norbornene, 5-isopropylidene-2-norbornene, 5-(2-propenyl)-2-norbornene, 5-(3-butenyl)-2-norbornene, 5-(1-methyl-2-propenyl)-2-norbornene, 5-(4-pentenyl)-2-norbornene, 5-(1-methyl-3-butenyl)-2-norbornene, 5-(5-hexenyl)-2-norbornene, 5-(1-methyl-4-pentenyl)-2-norbornene, 5-(2,3-dimethyl-3-butenyl)-2-norbornene, 5-(2-ethyl-3-butenyl)-2-norbornene, 5-(3,4-dimethyl-4-pentenyl)-2-norbornene, 5-(7-octenyl)-2-norbornene, 5-(2-methyl-6-heptenyl)-2-norbornene, 5-(1,2-dimethyl-5-hexenyl)-2-norbornene, 5-(5-ethyl-5-hexenyl)-2-norbornene and 5-(1,2,3-trimethyl-4-pentenyl)-2-norbornene; alkynyl-containing norbornenes such as 5-ethynyl-2-norbornene; alkoxysilyl-containing norbornenes such as dimethylbis((5-norbornene-2-yl)methoxy))silane; silyl-containing norbornenes such as 1,1,3,3,5,5-hexamethyl-1,5-dimethylbis((2-(5-norbornene-2-yl)ethyl )trisiloxane; aryl-containing norbornenes such as 5-phenyl-2-norbornene, 5-naphthyl-2-norbornene and 5-pentafluorophenyl-2-norbornene;aralkyl-containing norbornenes such as 5-benzyl-2-norbornene, 5-phenethyl-2-norbornene, 5-pentafluorophenylmethane-2-norbornene, 5-(2-pentafluorophenylethyl)-2-norbornene and 5-(3-pentafluorophenylpropyl)-2-norbornene; alkoxysilyl-containing norbornenes such as 5-trimethoxysilyl-2-norbornene, 5-triethoxysilyl-2-norbornene, 5-(2-trimethoxysilylethyl)-2-norbornene, 5-(2-triethoxysilylethyl)-2-norbornene, 5-(3-trimethoxypropyl)-2-norbornene, 5-(4-trimethoxybutyl)-2-norbornene and 5-trimethylsilylmethylether-2-norbornene.

Examples of a photoreactive functional group in (A) a cyclic olefinic compound having a photoreactive functional group are, but not limited to, epoxy and oxetanyl in the light of light resolution and mechanical strength after curing. Among others, the composition contains preferably an epoxy-containing norbornene resin as (A) a cyclic olefinic compound having a photoreactive functional group. The use of an epoxy-containing norbornene resin allows for ensuring heat resistance and mechanical strength of a resin composition after curing.

(A) A cyclic olefinic compound having a photoreactive functional group can be, in addition to a cyclic olefinic monomer having a photoreactive functional group, a polymer of a cyclic olefinic monomer having a photoreactive functional group with another monomer. In the light of light resolution and mechanical strength after curing, a polymerization rate of the cyclic olefinic monomer having a photoreactive functional group is preferably 20 to 80 mol%, more preferably 30 to 70 mol%.

Examples of the other monomer include, but not limited to, alkyl-containing monomers such as 5-methyl-2-norbornene, 5-ethyl-2-norbornene, 5-propyl-2-norbornene, 5-butyl-2-norbornene, 5-pentyl-2-norbornene, 5-hexyl-2-norbornene, 5-heptyl-2-norbornene, 5-octyl-2-norbornene, 5-nonyl-2-norbornene and 5-decyl-2-norbornene; alkenyl-containing monomers such as 5-allyl-2-norbornene, 5-methylidene-2-norbornene, 5-ethylidene-2-norbornene, 5-isopropylidene-2-norbornene, 5-(2-propenyl)-2-norbornene, 5-(3-butenyl)-2-norbornene, 5-(1-methyl-2-propenyl)-2-norbornene, 5-(4-pentenyl)-2-norbornene, 5-(1-methyl-3-butenyl)-2-norbornene, 5-(5-hexenyl)-2-norbornene, 5-(1-methyl-4-pentenyl)-2-norbornene, 5-(2,3-dimethyl-3-butenyl)-2-norbornene, 5-(2-ethyl-3-butenyl)-2-norbornene, 5-(3,4-dimethyl-4-pentenyl)-2-norbornene, 5-(7-octenyl)-2-norbornene, 5-(2-methyl-6-heptenyl)-2-norbornene, 5-(1,2-dimethyl-5-hexenyl)-2-norbornene, 5-(5-ethyl-5-hexenyl)-2-norbornene and 5-(1,2,3-trimethyl-4-pentenyl)-2-norbornene; alkynyl-containing monomers such as 5-ethynyl-2-norbornene; alkoxysilyl-containing monomers such as dimethylbis((5-norbornene-2-yl)methoxy))silane; silyl-containing monomers such as 1,1,3,3,5,5-hexamethyl-1,5-dimethylbis((2-(5-norbornene-2-yl)ethyl )trisiloxane; aryl-containing monomers such as 5-phenyl-2-norbornene, 5-naphthyl-2-norbornene, 5-pentafluorophenyl-2-norbornene; aralkyl-containing monomers such as 5-benzyl-2-norbornene, 5-phenethyl-2-norbornene, 5-pentafluorophenylmethane-2-norbornene, 5-(2-pentafluorophenylethyl)-2-norbornene and 5-(3-pentafluorophenylpropyl)-2-norbornene; alkoxysilyl-containing monomers such as 5-trimethoxysilyl-2-norbornene, 5-triethoxysilyl-2-norbornene, 5-(2-trimethoxysilylethyl)-2-norbornene, 5-(2-triethoxysilylethyl)-2-norbornene, 5-(3-trimethoxypropyl)-2-norbornene, 5-(4-trimethoxybutyl)-2-norbornene, 5-trimethylsilylmethylether-2-norbornene; monomers having hydroxy, ether, carboxyl, ester, acryloyl or methacryloyl such as 5-norbornene-2-methanol and its alkyl ether, acetic acid 5-norbornene-2-methyl ester, propionic acid 5-norbornene-2-methyl ester, butyric acid 5-norbornene-2-methyl ester, valeric acid 5-norbornene-2-methyl ester, caproic acid 5-norbornene-2-methyl ester, caprylic acid 5-norbornene-2-methyl ester, capric acid 5-norbornene-2-methyl ester, lauric acid 5-norbornene-2-methyl ester, stearic acid 5-norbornene-2-methyl ester, oleic acid 5-norbornene-2-methyl ester, linolenic acid 5-norbornene-2-methyl ester, 5-norbornene-2-carboxylic acid, 5-norbornene-2-carboxylic acid methyl ester, 5-norbornene-2-carboxylic acid ethyl ester, 5-norbornene-2-carboxylic acid t-butyl ester, 5-norbornene-2-carboxylic acid i-butyl ester, 5-norbornene-2-carboxylic acid trimethylsilyl ester, 5-norbornene-2-carboxylic acid triethylsilyl ester, 5-norbornene-2-carboxylic acid isobornyl ester, 5-norbornene-2-carboxylic acid 2-hydroxyethyl ester, 5-norbornene-2-methyl-2-carboxylic acid methyl ester, cinnamic acid 5-norbornene-2-methyl ester, 5-norbornene-2-methyl ethyl carbonate, 5-norbornene-2-methyln-butylcarbonate,5-norbornene-2-methylt-butyl carbonate, 5-methoxy-2-norbornene, (meth)acrylic acid 5-norbornene-2-methyl ester, (meth) acrylic acid 5-norbornene-2-ethyl ester, (meth) acrylic acid 5-norbornene-2-n-butyl ester, (meth) acrylic acid 5-norbornene-2-n-propyl ester, (meth)acrylic acid 5-norbornene-2-i-butyl ester, (meth)acrylic acid 5-norbornene-2-i-propylester, (meth)acrylic acid 5-norbornene-2-hexyl ester, (meth) acrylic acid 5-norbornene-2-octyl ester and (meth)acrylic acid 5-norbornene-2-decyl ester; epoxy-containing monomers such as 5-[(2,3-epoxypropoxy)methyl]-2-norbornene; tetracyclo-ring containing monomers such as 8-methoxycarbonyltetracyclo[4.4.0.$1^{2,5}.1^{7,10}$]dodec-3-ene, 8-ethoxycarbonyltetracyclo[4.4.0.$1^{2,5}.1^{7,10}$] dodec-3-ene, 8-n-propylcarbonyltetracyclo[4.4.0.$1^{2,5}.1^{7,10}$]dodec-3-ene, 8-i-propylcarbonyltetracyclo[4.4.0.$1^{2,5}.1^{7,10}$]dodec-3-ene, 8-n-butoxycarbonyltetracyclo[4.4.0.$1^{2,5}.1^{7,10}$]dodec-3-ene, 8-(2-methylpropoxy)carbonyltetracyclo[4.4.0.$1^{2,5}.1^{7,10}$]dodec-3-ene, 8-(1-methylpropoxy)carbonyltetracyclo[4.4.0.$1^{2,5}.1^{7,10}$]dodec-3-ene, 8-t-butoxycarbonyltetracyclo[4.4.0.$1^{2,5}.1^{7,10}$]dodec-3-ene, 8-cyclohexyloxycarbonyltetracyclo[4.4.0.$1^{2,5}.1^{7,10}$]dodec-3-ene, 8-(4'-t-butylcyclohexyloxy)carbonyltetracyclo[4.4.0.$1^{2,5}.1^{7,10}$]dodec-3-ene, 8-phenoxycarbonyltetracyclo [4.4.0.$1^{2,5}.1^{7,10}$]dodec-3-ene, 8-tetrahydrofranyloxycarbonyltetracyclo[4.4.0.$1^{2,5}.1^{7,10}$]-3-dodecene, 8-tetrahydropyranyloxycarbonyltetracyclo[4.4.0.$1^{2,5}.1^{7,10}$]dodec-3-ene, 8-methyl-8-methoxycarbonyltetracyclo[4.4.0.$1^{2,5}.1^{7,10}$]dodec-3-ene, 8-methyl-8-ethoxycarbonyltetracyclo[4.4.0.$1^{2,5}.1^{7,10}$]dodec-3-ene, 8-methyl-8-n-propoxycarbonyltetracyclo [4.4.0.$1^{2,5}.1^{7,10}$]dodec-3-ene, 8-methyl-8-i-propoxycarbonyltetracyclo[4.4.0.$1^{2,5}.1^{7,10}$]dodec-3-ene, 8-methyl-8-n-butoxycarbonyltetracyclo[4.4.0.$1^{2,5}.1^{7,10}$]dodec-3-ene, 8-methyl-8-(2-methylpropoxy)carbonyltetracyclo[4.4.0.$1^{2,5}.1^{7,10}$] dodec -3-ene, 8-methyl-8-(1-methylpropoxy)carbonyltetracyclo[4.4.0.$1^{2,5}.1^{7,10}$]dodec -3-ene, 8-methyl-8-t-butoxycarbonyltetracyclo[4.4.0.$1^{2,5}.1^{7,10}$]dodec-3-ene, 8-methyl-8-cyclohexyloxycarbonyltetracyclo[4.4.0.$1^{2,5}.1^{7,10}$]dodec-3-e ne, 8-methyl-8-(4'-t-butylcyclohexyloxy)carbonyltetracyclo[4.4.0.$1^{2,5}.1^{7,10}$]dodec-3-ene, 8-methyl-8-phenoxycarbonyltetracyclo[4.4.0.$1^{2,5}.1^{7,10}$]dodec-3-ene, 8-methyl-8-tetrahydrofranyloxycarbonyltetracyclo[4.4.0.$1^{2,5}.1^{7,10}$]dod ec-3-ene, 8-methyl-8-tetrahydropyranyloxycarbonyltetracyclo[4.4.0.$1^{2,5}.1^{7,10}$]-3 -dodecene, 8-methyl-8-acetoxytetracyclo [4.4.0.$1^{2,5}.1^{7,10}$]dodec-3-ene, 8,9-di(methoxycarbonyl)tetracyclo[4.4.0.$1^{2,5}.1^{7,10}$]dodec-3-ene, 8,9-di(ethoxycarbonyl) tetracyclo[4.4.0.$1^{2,5}.1^{7,10}$]dodec-3-ene, 8,9-di(n-propoxycarbonyl)tetracyclo[4.4.0.$1^{2,5}.1^{7,10}$]dodec-3-ene, 8,9-di(i-propoxycarbonyl)tetracyclo[4.4.0.$1^{2,5}.1^{7,10}$]dodec-3-ene, 8,9-di(n-butoxycarbonyl)tetracyclo[4.4.0.$1^{2,5}.1^{7,10}$]dodec-3-ene, 8,9-di(t-butoxycarbonyl)tetracyclo[4.4.0.$1^{2,5}.1^{7,10}$]dodec-3-ene, 8,9-di(cyclohexyloxycarbonyl)tetracyclo[4.4.0.$1^{2,5}.1^{7,10}$]dodec-3-ene, 8,9-di(phenoxyloxycarbonyl)tetracyclo[4.4.0.$1^{2,5}.1^{7,10}$]dodec-3-ene, 8,9-di(tetrahydrofranyloxycarbonyl)tetracyclo[4.4.0.$1^{2,5}.1^{7,10}$]-3-dod ecene, 8,-9-di(tetrahydropyranyloxycarbonyl)tetracyclo[4.4.0.$1^{2,5}.1^{7,10}$]-3-dodecene, 8,9-tetracyclo[4.4.0.$1^{2,5}.1^{7,10}$]dodec-3-ene, tetracyclo[4.4.0.$1^{2,5}.1^{7,10}$]dodec-3-ene-8-carboxylic acid, 8-methyltetracyclo[4.4.0.$1^{2,5}.1^{7,10}$]dodec-3-ene-8-carboxylic acid; 8-methyltetracyclo [4.4.0.$1^{2,5}.1^{7,10}$]dodec-3-ene, 8-ethyltetracyclo[4.4.0.$1^{2,5}.1^{7,10}$]dodec-3-ene, 8-methyltetracyclo[4.4.0.$1^{2,5}.0^{1,6}$]dodec-3-ene, 8-ethylidenetetracyclo[4.4.0.$1^{2,5}.1^{7,12}$]dodec-3-ene and 8-ethylidenetetracyclo[4.4.0.$1^{2,5}.1^{7,10}0^{1,6}$]dodec-3-ene.

The cyclic olefinic monomer can be polymerized by a known style such as, but not limited to, random polymerization and block polymerization, and a polymerization method includes addition polymerization and ring-opening polymerization. Specific polymers include (co) polymers of a norbornene monomer, copolymers of a norbornene monomer and another copolymerizable monomer such as an $\alpha$-olefin and hydrogen additives of these copolymers, and in the light of heat resistance of a resin, an addition polymer is preferable.

A weight-average molecular weight of (A) a cyclic olefinic compound having a photoreactive functional group is, but not limited to, preferably 5,000 to 500,000, particularly preferably 7,000 to 200,000 in the light of solubility in a solvent and flowability of a resin composition. A weight-average molecular weight can be measured by gel permeation

chromatography (GPC) using polynorbornene as a standard (in accordance with ASTMDS3635-91).

A weight-average molecular weight of (A) a cyclic olefinic compound having a photoreactive functional group can be controlled by changing a ratio of a polymerization initiator to a monomer or a polymerization time.

(B) An acid generator can be, with no limitations, any compound which generates a Broensted acid or Lewis acid by the action of light or heat, and can initiate polymerization of (C) a curable compound. Examples of (B) the acid generator include, but not limited to, onium salts, halogen compounds, sulfates and mixtures of these. Examples of an onium salt include diazonium salts, ammonium salts, iodonium salts, sulfonium salts, phosphates, arsonium salts and oxonium salts, and there are no particular restrictions to a counter anion as long as it can be a counter anion of the onium salt. Examples of a counter anion include boric acid, arsonic acid, phosphoric acid, antimonic acid, sulfate and carboxylic acids and their halogenated derivatives.

Examples of the onium-salt acid generator include triphenylsulfonium tetrafluoroborate, triphenylsulfonium hexafluoroborate, triphenylsulfonium tetrafluoroarsenate, triphenylsulfonium tetrafluorophosphate, triphenylsulfonium tetrafluorosulfate, 4-thiophenoxydiphenylsulfonium tetrafluoroborate, 4-thiophenoxydiphenylsulfonium tetrafluoroantimonate, 4-thiophenoxydiphenylsulfonium tetrafluoroarsenate, 4-thiophenoxydiphenylsulfonium tetrafluorophosphate, 4-thiophenoxydiphenylsulfonium tetrafluorosulfonate, tris(t-butylphenyl)sulfonium tetrakis(pentafluorophenyl)borate, 4-t-butylphenyldiphenylsulfonium tetrafluoroborate, 4-t-butylphenyldiphenylsulfonium tetrafluorosulfonium , 4-t-butylphenyldiphenylsulfonium tetrafluoroantimonate, 4-t-butylphenyldiphenylsulfonium trifluorophosphonate, 4-t-butylphenyldiphenylsulfonium trifluorosulfonate, tris(4-methylphenyl)sulfonium trifluoroborate, 4,4',4''-tris(t-butylphenyl)sulfonium triflate, tris(4-methylphenyl)sulfonium tetrafluoroborate, tris(4-methylphenyl)sulfonium hexafluoroarsenate, tris(4-methylphenyl)sulfonium hexafluorophosphate, tris(4-methylphenyl)sulfonium hexafluorosulfonate, tris(4-methoxyphenyl)sulfonium tetrafluoroborate, tris(4-methylphenyl)sulfonium hexafluoroantimonate, tris(4-methylphenyl)sulfonium hexafluorophosphate, tris(4-methylphenyl)sulfoniumtrifluorosulfonate, triphenylsulfonium diphenyliodonium tetrakis(pentafluorophenyl)borate, diphenyliodonium tetrakis(pentafluorophenyl)borate, triphenyliodonium tetrafluoroborate, triphenyliodonium hexafluoroantimonate, triphenyliodonium hexafluoroarsenate, triphenyliodonium hexafluorophosphate, triphenyliodonium trifluorosulfonate, 3,3-dinitrodiphenyliodonium tetrafluoroborate, 3,3-dinitrodiphenyliodonium hexafluoroantimonate, 3,3-dinitrodiphenyliodonium hexafluoroarsenate, 3,3-dinitrodiphenyliodonium trifluorosulfonate, 4,4'-di-t-butylphenyliodonium triflate, 4,4'-di-t-butylphenyliodonium tetrakis(pentafluorophenyl)borate, 4,4-dinitrodiphenyliodonium tetrafluoroborate, 4,4-dinitrodiphenyliodonium hexafluoroantimonate, 4,4-dinitrodiphenyliodonium hexafluoroarsenate, 4,4-dinitrodiphenyliodonium trifluorosulfonate and (4-methylphenyl-4-(1-methylethyl)phenyliodonium tetrakis(pentafluorophenyl)borate, which can be used alone or in combination.

Examples of a halogen-containing acid generator include 2,4,6-tris(trichloromethyl)triazine, 2-allyl-4,6-bis (trichloromethyl)triazine, $\alpha,\beta,\alpha$-tribromomethyl phenyl sulfone, $\alpha,\alpha$-2,3,5,6-hexachloroxylene, 2,2-bis(3,5-dibromo-4-hydroxyphenyl)-1,1,1,3,3,3-hexafluoroxylene and 1,1,1-tris(3,5-dibromo-4-hydroxyphenyl)ethane, which can be used alone or in combination.

Specific examples of a sulfonate acid generator include 2-nitrobenzyl tosylate, 2, 6-dinitrobenzyl tosylate, 2,4-dinitrobenzyl tosylate, 2-nitrobenzylmethyl sulfonate, 2-nitrobenzyl acetate, 9,10-dimethoxyanthracene-2-sulfonate, 1,2,3-tris(methanesulfonyloxy)benzene, 1,2,3-tris(ethanesulfonyloxy)benzene and 1,2,3-tris(propanesulfonyloxy)benzene, which can be used alone or in combination.

Among the above acid generators, preferred are one or a combination of two or more selected from 4,4'-di-t-butylphenyliodonium triflate, 4,4',4''-tris(t-butylphenyl)sulfonium triflate, diphenyliodonium tetrakis(pentafluorophenyl) borate, triphenylsulfonium diphenyliodonium tetrakis(pentafluorophenyl)borate, 4,4'-di-t-butylphenyliodonium tetrakis (pentafluorophenyl)borate, tris(t-butylphenyl)sulfonium tetrakis(pentafluorophenyl)borate and (4-methylphenyl-4-(1-methylethyl)phenyliodonium tetrakis(pentafluorophenyl)borate. Thus, (C) a curable compound can be crosslinked by the action of an acid generator and adhesiveness to a substrate can be improved.

The content of (B) the acid generator is, but not limited to, preferably 0.1 to 20 parts by weight, particularly preferably 0.5 to 10 parts by weight to 100 parts by weight as the total of (A) a cyclic olefinic compound having the above functional group and (C) a compound curable by the action of an acid generator. The content within the above range can provide particularly excellent an opening shape after light resolution and sensitivity.

There are no particular restrictions to (C) a compound curable by the action of an acid generator as long as it can be cured by the action of an acid generator, but (A) a cyclic olefinic resin having a photoreactive functional group is excluded.

(C) A compound curable by the action of an acid generator is preferably, but not limited to, liquid at room temperature. The compound as a liquid at room temperature can be viscous, so that wettability to a bonded material can be improved and therefore, adhesiveness after photocuring of the resin composition can be further improved.

(C) A compound curable by the action of an acid generator preferably has a weight-average molecular weight of, but not limited to, 1, 000 or less, particularly preferably 100 to 600. A weight-average molecular weight within the above range provides particularly excellent flowability during heating.

The content of (C) a compound curable by the action of an acid generator is, but not limited to, preferably 1 to

50 parts by weight, particularly preferably 10 to 40 parts by weight to 100 parts by weight of (A) a cyclic olefinic resin having a photoreactive functional group. Within the above range, both adhesiveness after curing of the resin composition and proper flowability can be achieved.

Examples of (C) a compound curable by the action of an acid generator include, but not limited to, epoxy compounds, oxetane compounds, vinyl compounds, acrylic compounds, polyols and phenol compounds, and in the light of curability, heat resistance, moisture resistance and mechanical properties of a photosensitive resin composition after curing, epoxy compounds and oxetane compounds are preferable and epoxy compounds and oxetanyl compounds are particularly preferable.

Examples of the epoxy compound include, but not limited to, novolac type phenol resins such as bisphenol-A novolac resin; phenol resins such as resol type phenol resins including unmodified resol phenol resin and oil-modified resol phenol resin which is modified by, for example, wood oil; bisphenol type epoxy resins such as bisphenol-A type epoxy resin and bisphenol-F type epoxy resin; novolac type epoxy resins such as phenol novolac type epoxy resin and cresol novolac type epoxy resin; and epoxy resins such as biphenyl type epoxy resin, hydroquinone type epoxy resin, stilbene type epoxy resin, triphenolmethane type epoxy resin, triazine-nucleus containing epoxy resin, cycloalkane type epoxy resin including dicyclopentadimethanol type, dicyclopentadiene-modified phenol type epoxy resin, naphthol type epoxy resin, phenolaralkyl type epoxy resin and naphtholaralkyl type epoxy resin (in addition, siloxane type), which can be used alone or in combination of two or more.
Among these, an epoxy compound having a cycloalkane type, a bisphenol type or a siloxane type are preferable in the light of compatibility with a resin and light resolution, and a cycloalkane type is particularly preferable.
Furthermore, since when the epoxy compound is monofunctional, a crosslink density is reduced leading to deterioration in heat resistance, the compound is preferably bi- or further functional.

The oxetane compound can be selected from, but not limited to, oxetane compounds represented by general formula (1):

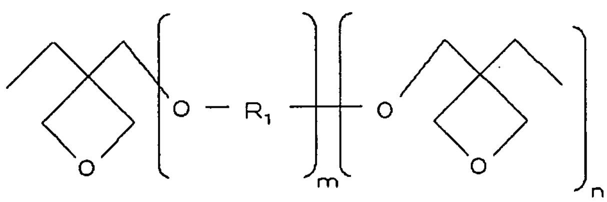 (1)

wherein R1 is an organic group; m is an integer of 0 to 10; n is 0 or 1, provided that when m = 0, then n = 1 and when n = 0, then m = 1, which can be used alone or in combination of two or more.
$R_1$ is, but not limited to, hydrogen (only when n = 0), phenyl, benzyl, 2-ethylhexyl or triethoxysilylpropyl.

Among the oxetane compounds represented by general formula (1), preferred are 1,4-bis{[(3-ethyl-3-oxetanyl) methoxy]methyl}benzene, bis(3-ethyl-3-oxetanylmethyl) ether, 4,4-bis[(3-ethyl-3-oxetanyl)methoxy]biphenyl and 3-ethyl-3-[(2-ethylhexyloxy)methyl]oxetane, and particularly preferred is 1,4-bis{[(3-ethyl-3-oxetanyl)methoxy]methyl}benzene in the light of compatibility with a resin and light resolution.

In the oxetane compound represented by general formula (1), m is an integer of 0 to 10 and n is 0 or 1, provided that when m = 0, then n = 1 and when n = 0, then m = 1.
With m of 0 to 10, both flowability and curability can be achieved. With n of 0 or 1, excessive crosslinking of the resin composition can be prevented, so that both adhesiveness and mechanical strength can be achieved.

The resin composition can contain (D) a sensitizer for improving sensitivity of (B) the acid generator. Examples of a sensitizer include, but not limited to, cycloaromatics such as 2-isopropyl-9H-thioxantene-9-ene, 4-isopropyl-9H-thioxantene-9-one, 1-chloro-4-propoxy-9H-thioxantene-9-one and phenothiazine, which can be used alone or in combination of two or more. Among these, 4-isopropyl-9H-thioxantene-9-one and 1-chloro-4-propoxy-9H-thioxantene-9-one are preferably and 1-chloro-4-propoxy-9H-thioxantene-9-one is particularly preferable in the light of improving sensitivity to i-line of an acid generator.

The resin composition can contain (E) an acid-diffusion inhibitor for improving resolution by absorbing an acid diffusing to an unexposed part in the resin composition. Examples of an acid-diffusion inhibitor include, but not limited to, pyridine, lutidine, phenothiazine, tri-n-propylamine and secondary and tertiary amine such as triethylamine, which can be used alone or in combination of two or more. Among these, phenothiazine is particularly preferable in the light of improving resolution.

The resin composition can contain (F) an antioxidant for preventing the resin composition from being oxidized

by heat. Examples of an antioxidant include, but not limited to, hindered phenol antioxidants, phosphorous antioxidants and thioether antioxidants, which can be used alone or in combination of two or more. Among these, hindered phenol antioxidants and phosphorous antioxidants are preferable and hindered phenol antioxidants are particularly preferable in the light of mechanical strength of the resin composition.

The resin composition can contain, in addition to the above components, a leveling agent, a flame retardant, a plasticizer and a silane coupling agent.

When the resin composition described above is used, a temperature at which pressure-bonding is maintained is around 200 ˚C.

Furthermore, in the embodiment, the transparent substrate 13 and the base substrate 12 having the light receiving unit 11 are bonded, but without being limited to the embodiment, a substrate and electronic components can be bonded in any style in the present invention.

Furthermore, in the embodiment, the resin composition constituting the adhesion layer 15 contains a photocurable resin and a thermosetting resin, but without being limited to the embodiment, for example, the composition can contain a photocurable resin and a thermoplastic resin.

## EXAMPLES

### Example 1

A light receiving device was produced as described in the above embodiment.

#### Synthesis of a methacryloyl-modified novolac type bisphenol-A resin MPN001

In a two liter flask was charged 500 g of a solution of a novolac type bisphenol-A resin (Phenolite LF-4871, Dainippon Ink and Chemicals, Incorporated.) in MEK (methyl ethyl ketone) with a solid content of 60 % and then added 1.5 g of tributylamine as a catalyst and 0.15 g of hydroquinone as a polymerization inhibitor, and the mixture was heated to 100 ˚C. To the mixture was added dropwise 180.9 g of glycidyl methacrylate over 30 min, and the reaction was stirred at 100 ˚C for 5 hours, to give a methacryloyl-modified novolac type bisphenol-A resin MPN001 (methacryloyl modification rate: 50 %) with a solid content of 74 %.

#### Preparation of a resin composition varnish

In MEK(methyl ethyl ketone, Daishin Chemical Co. Ltd.) were dissolved 31.8 % by weight of a methacryloyl-modified novolac type bisphenol-A resin MPN001 as a resin curable by both light and heat, 15.0 % by weight of a bisphenol-A novolac type epoxy resin (Dainippon Ink and Chemicals, Incorporated., trade name: N865) as a thermosetting resin, 3.6 % by weight of silicone-modified epoxy resin (Dow Corning Toray Silicone Co. Ltd., trade name: BY16-115) and 14.7 % by weight of triethyleneglycol dimethacrylate (Shin-nakamura Chemical Corporation, trade name: NK ester 3G) as a photocurable resin to give a resin composition varnish with a solid concentration of 71 %.

Next, 33.7 % by weight of silica (Admatechs Company Ltd., SO-E2, average particle size: 0.5μm, maximumparticle size: 2.0 μm) was dispersed as a filler.

Then, as a photopolymerization initiator, 1.2 % by weight of 2,2-dimethoxy-1,2-diphenylethane-1-one(Ciba Specialty ChemicalsInc., Irgacure651) was added and the mixture was stirred by a stirring blade (450 rpm) for one hour to prepare a resin composition varnish. Here, the content of the methacryloyl-modified novolac type bisphenol-A resin MPN001 in the above resin composition varnish is that of a solid.

#### Preparation of an adhesion film

Then, the resin composition varnish was applied to a transparent PET (film thickness: 25 μm) , and dried at 80 ˚C for 15 min, to form an adhesion layer with a thickness of 50 μm, giving an adhesion film.

#### Production process for a light receiving device

The above adhesion film was laminated on a 8-inch semiconductor wafer having a light receiving unit (base substrate)(thickness: 300μ m) under the roll laminator conditions (roll temperature: 60 ˚C, speed: 0.3 m/min, syringe pressure: 2. 0 $kgf/cm^2$), giving a 8-inch semiconductor wafer having a light receiving unit with an adhesion layer. Then, a photomask was aligned with the 8-inch semiconductor wafer having a light receiving unit with an adhesion layer, which was exposed with a light with a wavelength of 365 nm at 700 $mJ/cm^2$, and then the transparent PET film was peeled off. Then, it was developed using 2.38 % TMAH under the conditions of a developer pressure: 0.3 MPa and time: 90

sec to form a frame consisting of the adhesion layer with a size of 5 mm × 5 mm and a width of 0.6 mm (a frame-shaped adhesion layer).
Subsequently, on a substrate bonder (SUSS Microtech AG. , SB8e) were set the 8-inch semiconductor wafer having a light receiving unit with the above frame and the 8-inch transparent substrate, and the 8-inch semiconductor wafer having a light receiving unit and the 8-inch transparent substrate were bonded under the conditions shown in Table 1-1. Specifically, in Example 1, heating of the 8-inch semiconductor wafer having a light receiving unit with the above frame and the 8-inch transparent substrate were started at 25 °C (in Table 1-1, a. heating-initiating temperature) and they were heated to 120 °C (in Table 1-1, e. peak temperature). A ramp up rate was 30 °C/min (in Table 1-1, b. ramp up rate). In the course of this heating process, when the system reached 36 °C pressure-bonding was initiated (in Table 1-1, c. pressure-bonding initiation temperature). Apressure-bondingpressure was 1.1 MPa (in Table 1-1, d. pressure-bonding pressure). A viscosity of the resin composition in the adhesion layer at the pressure-bonding initiating temperature was 72120 Pa·s and a pressure-bonding initiating temperature was a temperature at which a viscosity of the resin composition constituting the adhesion layer was 95 % of a viscosity of the resin composition at 25 °C.
Then, while maintaining pressure-bonding at 120 °C for 300 sec (in Table 1-1, e. peak temperature, f. heating maintaining time), the 8-inch semiconductor wafer having a light receiving unit, the 8-inch transparent substrate and the adhesion layer under pressure were cooled and during the cooling process, the pressure was released.
A storage elastic modulus at 60 °C when the pressure was released (in Table 1-1, h. pressure release temperature) was 0.11 MPa.
Then, the product was post-cured under the conditions of 150 °C and 90 min. The adhered product of the 8-inch semiconductor wafer having a light receiving unit and the 8-inch transparent substrate was diced into a predetermined size using a dicing saw to give a light receiving device.

Examples 2 to 9

Light receiving devices were prepared as described in Example 1, except that the production conditions were as indicated in Table 1-1. In any of these examples, pressure-bonding was conducted during the heating process.

Comparative Example 1

The production conditions are as shown in Table 1-1.
In Comparative Example 1, a 8-inch semiconductor wafer having a light receiving unit, a 8-inch transparent substrate and an adhesion layer were pressed at room temperature, that is, a heating initiating temperature.
Otherwise, the conditions were as described in Example 1.

Calculation of T1, T2, T3 for a resin composition

Each adhesion film prepared in Examples and Comparative Example was exposed with a light having a wavelength of 365 nm at 700 mJ/$cm^2$. Then, the transparent PET was peeled off from the adhesion film, and three adhesion layers thus obtained were laminated and measured for a viscosity Eta and a storage elastic modulus G' using a dynamic mechanical analysis Rheo Stress RS150 (HAAKE, measuring frequency: 1 Hz, gap distance: 100 μm, measurement temperature range: 25 to 200 °C, ramp up rate: 10 °C/min). The adhesion films obtained in Examples and Comparative Example had a viscosity Eta of 76000 Pa·s at 25 °C and a temperature at which the viscosity was 80 % of that at 25 °C was 41 °C (T1). A minimum melt viscosity was 0.03 MPa at a temperature of 100 °C (T2).
Furthermore, a temperature T3 at which a storage elastic modulus was 0.03 MPa was 80 °C.

Viscosity ratio at a pressure-bonding temperature

A viscosity at pressure-bonding initiation temperature was read from the chart obtained in the above measurement and the ratio was calculated by the following equation.

$$\text{Viscosity ratio (\%)} = \{(\text{viscosity at a pressure-bonding initiation temperature})/(\text{viscosity at 25 °C})\} \times 100$$

Elastic modulus at a pressure release temperature

A storage elastic modulus at a pressure release temperature was read from the chart obtained in the above

measurement.

Evaluation of adhesiveness

Adhesiveness for the light receiving devices prepared (n = 10) was determined as a Die shear strength.

Evaluation of void formation

Void formation in the adhesion layer in the light receiving device prepared (n = 10) was evaluated as follows. Voids in the adhesion layer were observed by a light microscope.

○○: bonding with no voids or microvoids.
○: 20 to 1 microvoids (less than 200 μm) are present.
×: voids (200 μm or more) are present.

Reliability evaluation

The light receiving device prepared (n = 10) was treated for 72 hours under the condition of 85 ˚C/85 %, and was subjected to reflow process at the highest temperature of 245 ˚C three times. Then, peel-off and cracks of the adhesion layer were observed and the results were evaluated as follows.

○: no detachment or cracks occurred in any sample (n = 10).
×: peel-off or cracks occurred in one or more samples.

Results

Examples 1 to 8 exhibited higher adhesiveness with little voids in the adhesion layer, resulting in high reliability. In contrast, Comparative Example exhibited lower adhesiveness with many voids in the adhesion layer, leading to deteriorated reliability.
Comparison of Example 1 with Examples 2 to 7 and 9 indicated that a pressure-bonding initiation temperature is preferably T1 at which a viscosity of the resin composition constituting the adhesion layer is 80 % of a viscosity of the resin composition at 25 ˚C, or a higher temperature.
Furthermore, comparison of Example 8 with Example 5 indicated that a pressure release temperature is preferably T3 or lower.
Table 1-1

| | Example 1 | Example 2 | Example 3 | Example 4 | Example 5 | Example 6 | Example 7 | Example 8 | Example 9 | Comparative Example 1 |
|---|---|---|---|---|---|---|---|---|---|---|
| a. Heating-initiating temperature (˚C) | 25 | 25 | 25 | 25 | 25 | 25 | 25 | 25 | 25 | 25 |
| b. Ramp up rate (˚C/min) | 30 | 30 | 30 | 30 | 30 | 30 | 30 | 30 | 30 | 30 |
| c. Pressure-bonding initiating temperature (˚C) | 36 | 43 | 50 | 73 | 100 | 50 | 50 | 100 | 100 | 25 |
| d. Pressure-bonding pressure (MPa) | 1.1 | 1.1 | 1.1 | 1.1 | 1.1 | 1.1 | 1.1 | 1.1 | 1.1 | 1.1 |
| e. Peak temperature (˚C) | 120 | 120 | 120 | 120 | 120 | 150 | 120 | 120 | 120 | 120 |
| f. Heating-maintaining time (sec) | 300 | 300 | 300 | 300 | 300 | 300 | 1800 | 300 | 300 | 300 |
| g. Time to reach a pressure release temperature (min) | 12 | 12 | 12 | 12 | 12 | 15 | 12 | 12 | 12 | 12 |
| h. Pressure release temperature (˚C) | 60 | 60 | 60 | 60 | 60 | 60 | 60 | 100 | 80 | 60 |

Table 1-2

| | Example 1 | Example 2 | Example 3 | Example 4 | Example 5 | Example 6 | Example 7 | Example 8 | Example 9 | Comparative Example 1 |
|---|---|---|---|---|---|---|---|---|---|---|
| Viscosity at a pressure-bonding initiating temperature (Pa·s) | 72120 | 57750 | 45220 | 10650 | 3458 | 45220 | 45220 | 3458 | 3458 | 76500 |
| Viscosity ratio at a pressure-bonding temperature (%) *1 | 95 | 76 | 60 | 14 | 5 | 60 | 60 | 5 | 5 | 100 |
| Elastic modulus G' at a pressure release temperature (MPa) | 0.11 | 0.11 | 0.11 | 0.11 | 0.11 | 0.11 | 0.11 | 0.01 | 0.03 | 0.87 |
| Adhesiveness evaluation (MPa) | 21 | 25 | 23 | 27 | 26 | 27 | 25 | 25 | 26 | 18 |
| Void evaluation | ○ | ○○ | ○○ | ○○ | ○○ | ○○ | ○○ | ○ | ○○ | × |
| Electronic device reliability | ○ | ○ | ○ | ○ | ○ | ○ | ○ | ○ | ○ | × |

*1

Viscosity ratio at a pressure-bonding temperature (%) = {(Viscosity at a pressure-bonding initiating temperature)/(Viscosity at 25 °C)} × 100

## Claims

1. A process for manufacturing an electronic device comprising an electronic component and a substrate which face each other and a frame-shaped adhesion layer, which bonds said electronic component to said substrate, containing a resin composition containing a photocurable resin, comprising
forming the resin composition constituting said adhesion layer on said substrate or said electronic component;
selectively exposing said resin composition with a light and developing the resin composition to form said frame-shaped adhesion layer in a predetermined region;
placing said electronic component and said substrate such that these face each other, through said adhesion layer;
heating said electronic component, said substrate and said adhesion layer to a predetermined temperature, in the course of which said electronic component and said substrate are pressure-bonded through said adhesion layer;
maintaining the pressure-bonding state of said electronic component, said substrate and said adhesion layer at said predetermined temperature; and
cooling said electronic component, said substrate and said adhesion layer.

2. The process for manufacturing an electronic device as claimed in Claim 1, wherein in said heating said electronic component, said substrate and said adhesion layer to a predetermined temperature, the pressure-bonding of said electronic component, said adhesion layer and said substrate is initiated at T1 at which the viscosity of said resin composition constituting said adhesion layer reaches 80 % of said resin composition at 25 ˚C, or a higher temperature.

3. The process for manufacturing an electronic device as claimed in Claim 2, wherein
said resin composition contains a thermosetting resin, and
in said heating said electronic component, said substrate and said adhesion layer to a predetermined temperature, the pressure-bonding of said electronic component, said adhesion layer and said substrate is initiated at T2 giving the lowest melt viscosity, which is determined by heating said resin composition constituting said adhesion layer from 25 ˚C to 250 ˚C at a ramp up rate of 10 ˚C/min, or a lower temperature.

4. The process for manufacturing an electronic device as claimed in Claim 3, wherein
in said cooling said electronic component, said substrate and said adhesion layer, a pressure applied to said electronic component, said substrate and said adhesion layer is released during said cooling said electronic component, said substrate and said adhesion layer.

5. The process for manufacturing an electronic device as claimed in Claim 4, wherein
said resin composition contains a thermosetting resin, and
in said cooling said electronic component, said substrate and said adhesion layer, a pressure applied to said electronic component, said substrate and said adhesion layer is released at T3 which is lower than said predetermined temperature and at which said resin composition has a storage elastic modulus G' of 0.03 MPa, or a lower temperature.

6. The process for manufacturing an electronic device as claimed in Claim 5, wherein
said resin composition contains

(i) an epoxy resin,
(ii) a photocurable resin and
(iii) a photopolymerization initiator.

7. The process for manufacturing an electronic device as claimed in any of Claims 1 to 6, wherein
in said pressure-bonding said electronic component and said substrate through said adhesion layer, said electronic component and said substrate are pressure-bonded through said adhesion layer when a temperature of said electronic component, said substrate and said adhesion layer is 40 ˚C or higher and 100 ˚C or lower.

8. The process for manufacturing an electronic device as claimed in any of Claims 1 to 7, wherein
said substrate is a transparent substrate, and
said electronic component has a light receiving unit and a base substrate on which the light receiving unit is formed, and the electronic device is a light receiving device.

Fig.1

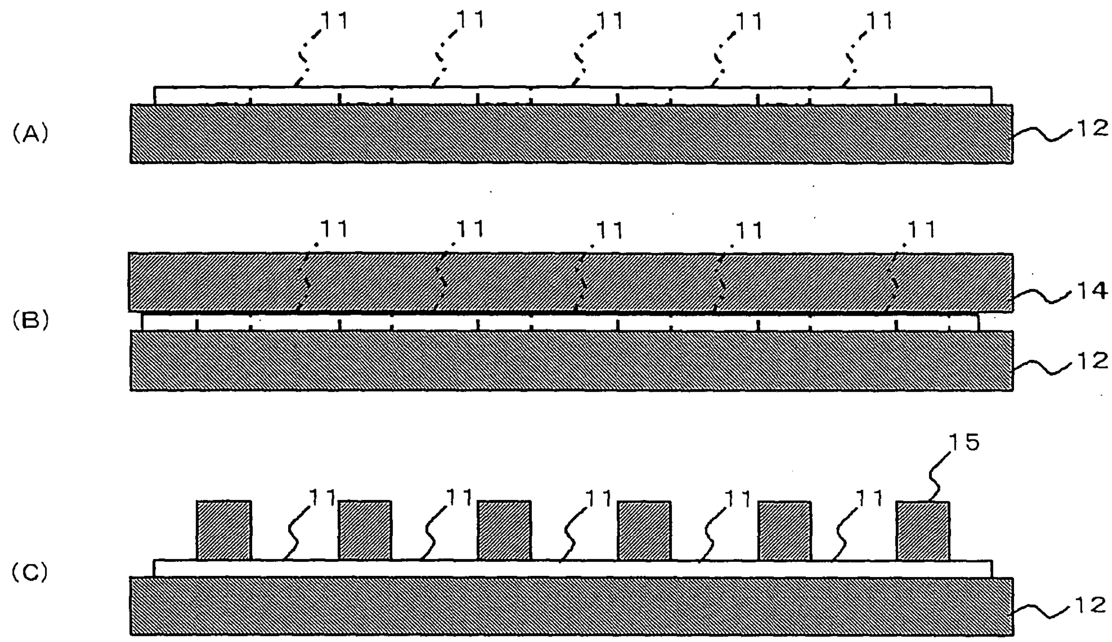

Fig.2

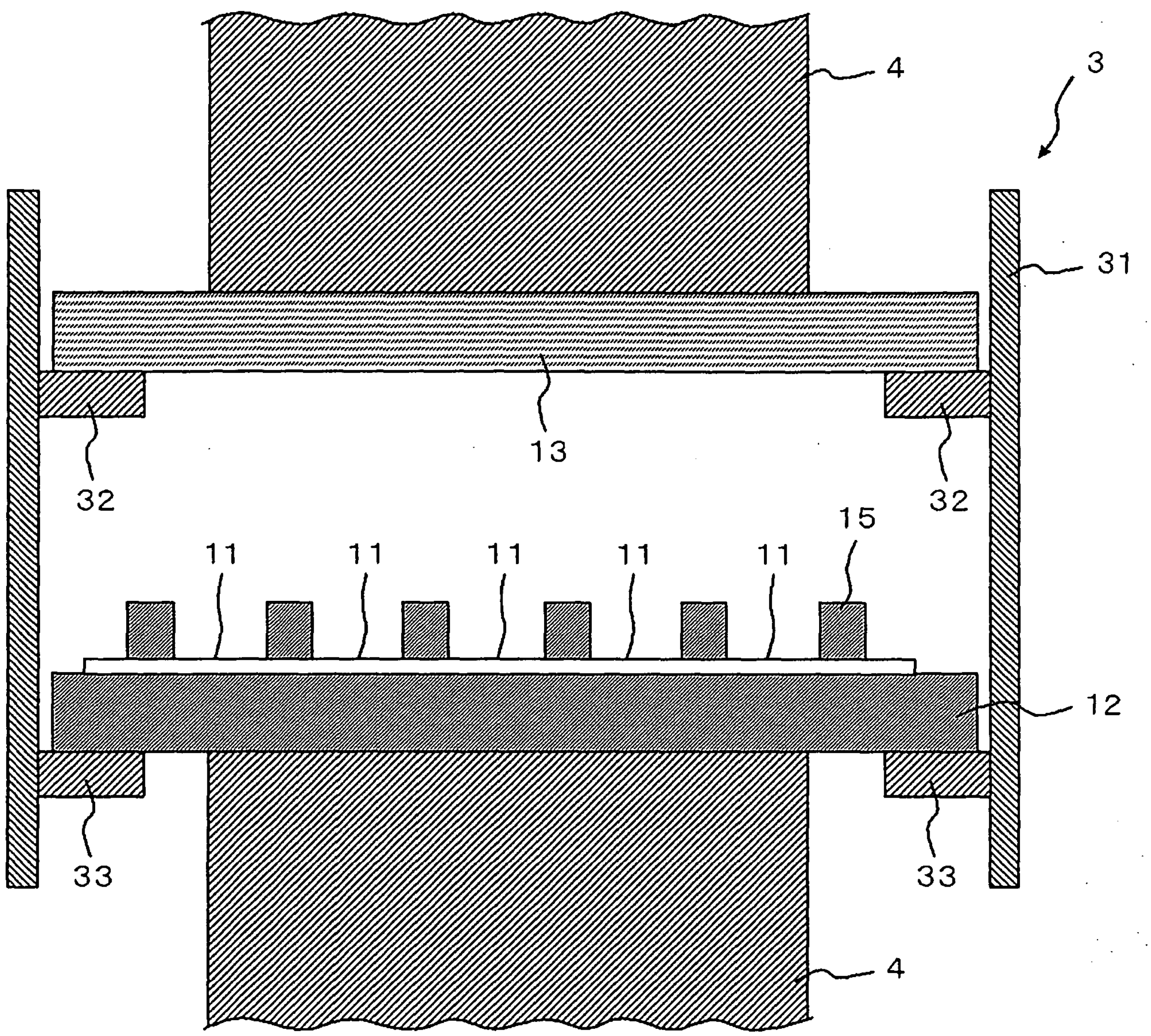

Fig.3

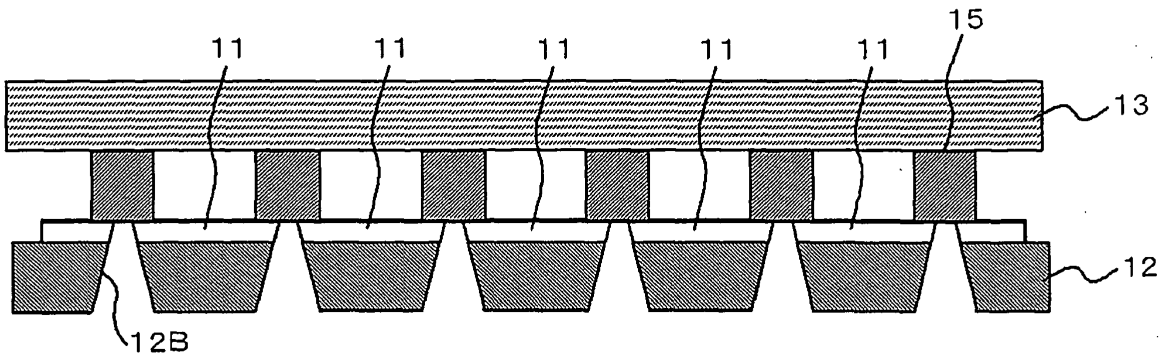

Fig.4

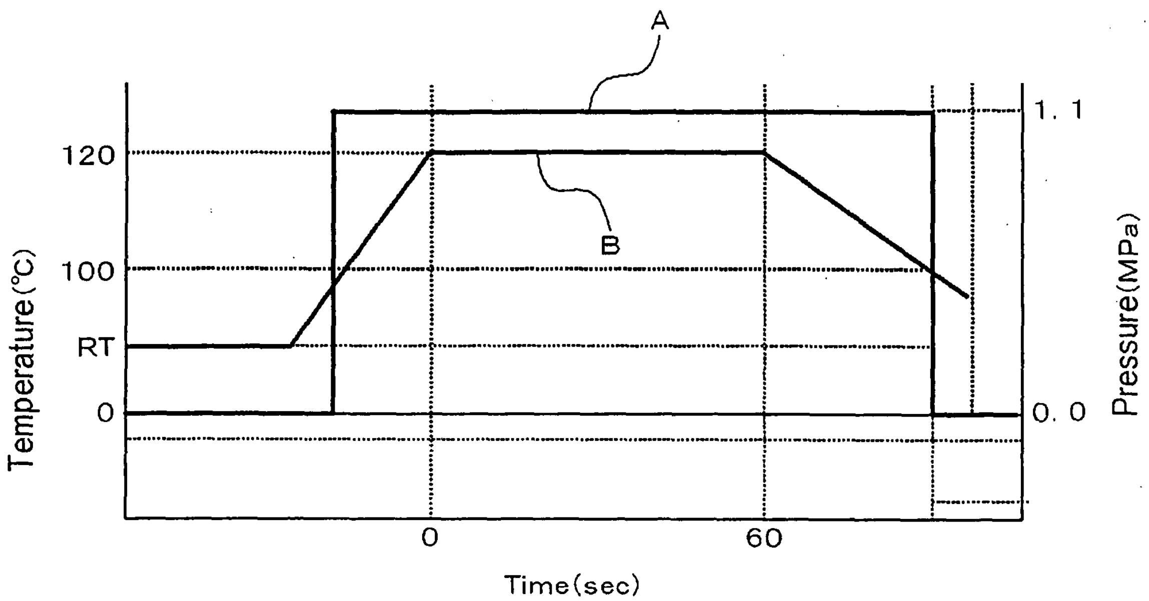

Fig.5

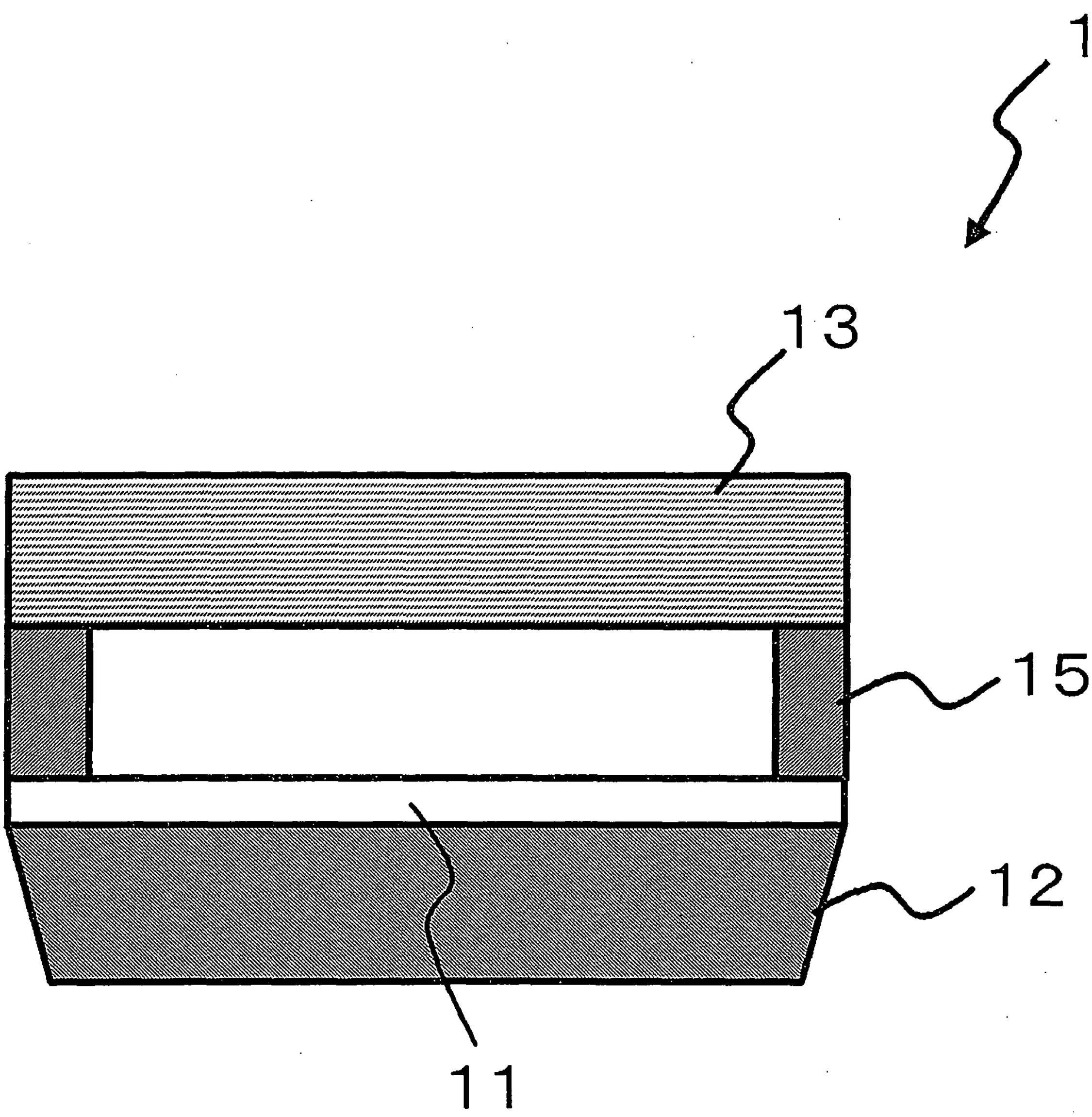

**INTERNATIONAL SEARCH REPORT**

International application No.
PCT/JP2008/001544

A. CLASSIFICATION OF SUBJECT MATTER
*H01L23/02*(2006.01)i, *H01L27/14*(2006.01)i, *H01L31/02*(2006.01)i

According to International Patent Classification (IPC) or to both national classification and IPC

B. FIELDS SEARCHED

Minimum documentation searched (classification system followed by classification symbols)
H01L23/02-H01L23/10, H01L27/14, H01L31/02

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | WO 2006/040986 A1 (Sumitomo Bakelite Co., Ltd.), 20 April, 2006 (20.04.06), Par. Nos. [0013] to [0019], [0066] to [0072]; Figs. 2 to 4 & EP 1804296 A1 | 1-8 |
| X | JP 2007-73958 A (Korea Advanced Institute Science and Technology), 22 March, 2007 (22.03.07), Par. Nos. [0036] to [0062]; Figs. 5 to 7 & US 2007/0054419 A1 & KR 10-2005-0093752 A | 1-5,7-8 |
| A | JP 2006-147864 A (Fujikura Ltd.), 08 June, 2006 (08.06.06), Par. Nos. [0018] to [0024]; Fig. 1 (Family: none) | 1-8 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 13 August, 2008 (13.08.08) | 26 August, 2008 (26.08.08) |
| Name and mailing address of the ISA/ Japanese Patent Office | Authorized officer |
| Facsimile No. | Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006070053 A